Europäisches Patentamt

(19) European Patent Office

Office européen des brevets

(11) Publication number: 0 260 577
A1

## EUROPEAN PATENT APPLICATION

(21) Application number: 87113093.6

(22) Date of filing: 08.09.87

(51) Int. Cl.⁴: C08F 20/06 , C08F 220/06 , C08L 33/02 , B01F 17/52 , H01G 1/01

(30) Priority: 11.09.86 US 905969

(43) Date of publication of application: 23.03.88 Bulletin 88/12

(84) Designated Contracting States: AT BE CH DE ES FR GB GR IT LI LU NL SE

(71) Applicant: The B.F. Goodrich Company 3925 Embassy Parkway Akron Ohio 44313(US)

(72) Inventor: Wilber, William Robert 32634 Admiral's Way Avon Lake Ohio 44012(US)

(74) Representative: von Kreisler, Alek, Dipl.-Chem. et al Deichmannhaus am Hauptbahnhof D-5000 Köln 1(DE)

(54) Ash-free multivalent cationstable dispersants for inorganic powders.

(57) The present invention resides in certain at least partially neutralized carboxylated acrylic polymers that are active dispersants for inorganic and metallic powders in aqueous vehicles. These carboxylated acrylic polymers are at least partially neutralized with quaternary organic ammonium hydroxides.

In one embodiment, such a neutralized carboxylated acrylic polymer comprises a water-soluble polymer having an acrylic backbone and carboxyl groups disposed at spaced locations along the backbone. This polymer is at least partially neutralized with a water-soluble quaternary organic ammonium hydroxide that neutralizes at least some of the carboxyl groups. The neutralized polymer is useful in dispersing in an aqueous medium a powder that can release into the aqueous medium one or more multivalent metal cations. The neutralized polymer is stable in solution against precipitation as a metal-polymer complex, at a concentration in the aqueous medium of multivalent cation released from said powder into the aqueous medium, and a concentration of dispersant polymer sufficient to effect dispersion of the inorganic powder.

The invention further resides in the use of such polymeric materials as dispersants, in aqueous formulations and compositions containing them, and in shapes such as green bodies made from such compositions.

EP 0 260 577 A1

# ASH-FREE, MULTIVALENT CATION-STABLE DISPERSANTS FOR INORGANIC POWDERS

This invention relates to certain carboxylated polymers that are at least partially neutralized with quaternary organic ammonium hydroxides. The invention also relates to the use of these neutralized polymers as dispersants for inorganic powders containing multivalent metals, in aqueous vehicles. The dispersions are useful in forming green bodies that can be fired to make ceramic articles, for example.

## BACKGROUND OF THE INVENTION

In the preparation of high quality porcelain ware, bone china, ceramic capacitors, ceramic insulators, what are known in the electronic industries as "thick film process" inks, and "thin film process" inks, ceramic "chip carriers", and ceramic substrates for thick film printing, it is a common practice to form a dispersion of the appropriate inorganic powder in an aqueous vehicle, with a binder.

The dispersion may contain several components. One or more of these components may be a material to assist in forming and/or maintaining the inorganic powder in a dispersed form. Such a dispersing agent may be a polymer that may also function as a binder. Another component may be a surface active agent that insures that the particles of the inorganic powder are readily wetted by the aqueous vehicle, so that they disperse readily and do not agglomerate or remain in undispersed clumps. Another component may be a binder polymer that, upon removal of the aqueous vehicle after casting the dispersion in a desired shape, sets, in the fashion that an adhesive sets, to function as a binder for the inorganic powder particles to hold them in the desired "green" shape pending firing.

For many of the desired applications for such dispersions, there may be two or more steps involved in making the final article. One of these steps may be that of casting the dispersion in the desired shape, then driving off the water and performing any other required steps to cause the active binder component to set or cure, to hold the inorganic particles in the desired "green" shape. The second step is that of pyrolysis. In this step, the shape is fired, that is, subjected to a very high temperature, to cause pyrolysis of the components of the binder and sintering, fusing, and/or glazing of the powder particles to form a fired product in the desired shape.

One of the problems with prior art active binder materials has been the undesirable property of such prior art binders of leaving a undesirable residue following pyrolysis. Some prior art dispersant materials, for example, have an affinity for multivalent cations, and extract them from the powder solids in the dispersion, so that upon pyrolysis, multivalent cations remain concentrated in certain areas of the fired material to act as impurity sites that may impart an undesired and uncontrolled variable in the electrical, chemical and/or physical properties of the pyrolysized product. These unwanted sites often may also serve as loci that are susceptible to chemical attack and that may be responsible for premature chemical and/or mechanical failure of the piece.

Other prior art materials initially are effective dispersants for the ceramic precursor powders, but are incompatible in solution at the effective dispersing concentration, with the concentration of multivalent cations released into aqueous solution by the ceramic precursor powder. This circumstance may occur upon the passage of time during storage of the slip or slurry, or may occur upon drying. This also results in localized concentrations of certain materials in the finished ceramic - heterogeneity which may be undesirable, as described above. For this reason, it is desirable that dispersant materials for powdered ceramic precursors be compatible with the ions released into solution by those powders.

Take, for example, calcium ion. The compatibility of a carboxylated acrylic polymer with calcium ion is conveniently reported in mg of calcium per 1,000 mg of the carboxylated acrylic polymer, for a specified pH or pH range. For example, the compatibility could be reported to be 32 mg of calcium per 1,000 mg of carboxylated acrylic polymer at a pH in the range of 6.0 to 10.0, at 22°C; above that level of calcium ion, the complex would precipitate.

Such unwanted sites may have their origin in the water employed in the production process. Ordinary water used in commercial operations is not pure, but contains a variety of cations, anions, dissolved gases and particulate matter. When such water is used in making a slip for making a ceramic green body, for example, all of those impurities are in the slip, and upon evaporation of the water, remain with the shaped green body. Thus, as the water is driven off from the shaped body, the anions and cations present in the initial water undergo a transition. Initially, the water is probably a very dilute solution of these materials. As water is driven off, however, the concentration of the impurities increases, and eventually, the concentration exceeds the saturation point, and solid materials are deposited or precipitated.

It is well known to those skilled in the art that the dispersing activity of any given dispersant for any given inorganic powder depends upon the pH. Many dispersants currently used in the art are at least partially neutralized with sodium or potassium to adjust the pH. Especially for such uses as the preparation of ceramic capacitors, the residues of these materials remaining after burnout are particularly undesirable.

To alleviate these problems, some consideration has been given in the past to neutralizing dispersant polymers with ammonium hydroxide or with primary, secondary or tertiary amines. However, such neutralized polymers encourage leaching of multivalent cations from inorganic powder slurries that contain multivalent cations which can form complexes with free amines. Such leaching removes the multivalent metal cation from the inorganic powder material in which it is bound, and after a slurry of such powder has been formed into a green shape and fired, the extracted multivalent cations form undesirable sites in the fired article. These sites result in unwanted modification of the chemical, physical, electrical characteristics of the fired product.

## SUMMARY OF THE INVENTION

The present invention resides in certain at least partially neutralized carboxylated acrylic polymers that are active dispersants for inorganic and metallic powders in aqueous vehicles. These carboxylated acrylic polymers are at least partially neutralized with quaternary organic ammonium hydroxides.

In one embodiment, such a neutralized carboxylated acrylic polymer comprises a water-soluble polymer having an acrylic backbone and carboxyl groups disposed at spaced locations along the backbone. This polymer is at least partially neutralized with a water-soluble quaternary organic ammonium hydroxide that neutralizes at least some of the carboxyl groups. The neutralized polymer is useful in dispersing in an aqueous medium a powder that can release into the aqueous medium one or more multivalent metal cations. The neutralized polymer is stable in solution against precipitation as a metal-polymer complex, at a concentration in the aqueous medium of multivalent cation released from said powder into the aqueous medium, and a concentration of dispersant polymer sufficient to effect dispersion of the inorganic powder.

The invention further resides in the use of such polymeric materials as dispersants, in aqueous formulations and compositions containing them, and in shapes such as green bodies made from such compositions.

## DETAILED DESCRIPTION OF THE INVENTION

In the following description of the invention, the term "polymer" is used in its broadest sense and embraces copolymers as well as homopolymers. The expression "fired product" is used here to refer not only to fired products but also to sintered, fused, glazed, cindered, and other products of pyrolysis or firing operations.

The initial step in the preparation of a dispersant in accordance with the invention is the preparation of a carboxylated acrylic polymeric backbone. Such a backbone polymer may be, for example, a polyacrylic acid prepared by solution polymerization in isopropanol at 100°C using a tertiary butyl perbenzoate catalyst. An operative weight average molecular weight for such a polyacrylic acid is in the range from about 500 atomic mass units to about 10,000 atomic mass units, with a preferred range being from 800 to 1250, and with a more preferred weight average molecular weight (Mw) range of from about 850 to 950. At the conclusion of polymerization, the isopropanol is distilled off, with the simultaneous or sequential addition of water, to produce an aqueous solution of the polyacrylic acid. One preferred Mw for polyacrylic acid is 909.

This polyacrylic acid is then neutralized with a quaternary organic ammonium hydroxide, preferably a tetra alkyl ammonium hydroxide, more preferably a tetra (lower alkyl) ammonium hydroxide, and most preferably a tetramethyl ammonium hydroxide. A sufficient quantity of the quaternary ammonium hydroxide is employed to achieve at least partial neutralization of the carboxyl groups and preferably substantial neutralization of the carboxyl groups.

The carboxylated acrylic polymer may be a copolymer. For example, acrylic acid may be copolymerized with a comonomer selected from the group consisting of hydroxy and polyhydroxy alkyl acrylates, hydroxy and polyhydroxy alkyl methacrylates, alkyl esters of acrylic and methacrylic acids, acrylamide, methacrylamide, 2-acrylamido-2-alkyl-alkane sulfonic acid, and the like. Preferably, the "alkyl" is lower alkyl, and the "alkane" is an alkane of not more than 4 carbon atoms. Maleic acid may also be employed as a comonomer, but when used, has the undesirable effect of lowering the compatibility of the neutralized, carboxylated copolymer with calcium ion. Among the preferred comonomers are methacrylic acid, hydroxy propyl acrylate, acrylamide, and 2-acrylamido-2-methyl-propane sulfonic acid.

A simple copolymer, that may be used, is a copolymer of acrylic acid with methacrylic acid. It is preferred that carboxyl units (-COOH) constitute from 12 % to 80% by weight of the polymer.

While the invention can be practiced by adjusting the percentage of carboxyl groups present by weight in the polymer, it is sometimes convenient to simply measure the amount of methacrylic acid or acrylic acid used in preparing the backbone polymer, when one or more comonomers is used, with one of these acids. Generally if at least 20% of acrylic acid is present in the monomer mixture from which the copolymer is formed, a sufficient number of carboxyl groups will be present.

Exemplary specific copolymers that have been evaluated, and their compatibility with calcium ion, are reported in Table 1 below.

## Table 1

### Compatibility of Calcium Ion with Several Copolymers
### (pH=8.0   T=22°C)

| Specimen No. | Polymer Composition | mg Ca/100 mg Polymer |
|---|---|---|
| 1 | AMPS | 100 |
| 2 | AA:AMPS (60:40) | 100 |
| 3 | AA:AMPS (70:30) | 84 |
| 4 | AA:AMPS (80:20) | 42 |
| 5 | AA:AM (10:90) | 100 |
| 6 | AA:MA (40:60) | 14 |
| 7 | AA:HPA (63:37) | 100 |
| 8 | AA | 52 |

AMPS = 2-acrylamido-2 methyl propane sulfonic acid.

AM   = acrylamide

MA   = maleic acid

AA   = acrylic acid

Other proportions of these comonomers can be used, but preferably the amount of acrylic acid is at least 20% by weight. If methacrylic acid is used as the sole source of carboxyl group then at least 25% should be used. More than two comonomers may also be used.

For purposes of the invention, the carboxyl groups in the polymer backbone are at least partially neutralized by reaction with a quaternary organic ammonium hydroxide. To effect this reaction, the water-soluble acrylic polymer is placed in aqueous solution and the quaternary compound is added. Generally the tetraalkyl quaternary ammonium hydroxides are preferred, and particularly, the tetra (lower alkyl) ammonium hydroxides, because of superior solubility in water. Among the preferred and generally available quaternary compounds are tetramethyl ammonium hydroxide, tetraethyl ammonium hydroxide, tetrapropyl ammonium hydroxide, tetrabutyl ammonium hydroxide, methyl triethyl ammonium hydroxide, methyl tripropyl ammonium hydroxide, methyl tributyl ammonium hydroxide, and methyl triethanol ammonium hydroxide. Other quaternary ammonium hydroxides that can be used include aryl trialkyl ammonium hydroxides, trialkyl benzyl ammonium hydroxide such as triethyl benzyl ammonium hydroxide, and alpha phenol triethyl ammonium hydroxide.

Generally, the carboxylated acrylic polymer is reacted with a sufficient amount of the quaternary organic ammonium hydroxide to effect at least partial neutralization. However, complete neutralization is not essential. The desired properties may be observed when at least about 10% by weight of the available carboxyl groups are neutralized. Preferably, from about 40% to about 100% of the available carboxyl groups are neutralized. The term "available" is used because, in the process of polymerizing the carboxylated acrylic monomer in isopropanol or other organic alcohol solvent, some carboxyl groups become esterified. Generally the esterified carboxyl groups, that is, those carboxyl groups originally present in the monomers as carboxylic acid, and esterified during polymerization, represent a minor proportion of the total, usually less than about 80% of all available carboxyl groups.

In characterizing the percentages of esterified and neutralized carboxyl groups, care must be taken to state the base to which the percentage applies. In this application, unless stated otherwise, the percentage expressed is based on the total of those carboxyl groups originally present in the monomer as carboxylic acid. Another way of characterizing a polymeric dispersant, in terms of the state of the carboxyl groups, is by numerical ratios, such as, for example, 1:1:1, to refer to the approximate numbers of carboxyls, of total carboxyls present in the monomer, that are in the form of esterified carboxyl, neutralized carboxyl, and -COOH.

In the practice of the invention, a slurry is made up from an aqueous vehicle and a powdered inorganic material, generally either a salt or a metal, that can release multivalent cations into the aqueous vehicle. For electronic applications, the aqueous vehicle frequently will be deionized or demineralized water. The powdered material that is dispersed in the aqueous vehicle generally will have powder particle sizes in the range of from about 1,000 mesh to about 60 mesh U.S. Standard Sieve size. Particles having a nominal size of through 1,000 mesh generally are in the range from about $2\frac{1}{2}$ micrometers in diameter to about 30 micrometers in diameter, with an average particle size of 6 to 7 micrometers, it being understood that the expression "diameter" is used here in its usual sense when referring to very fine particles, to refer to the largest dimension of the particle. Particles passing through 60 mesh screen size are about 217 micrometers or less in size. For making high quality electronic components that are ceramic in nature, such fine particle sizes often produce desirable and superior results.

Such fine particle sizes may be produced by grinding, or more preferably in some cases, by chemical precipitation under controlled conditions to produce fine particle sizes.

Often the multivalent cation present in the powder material will be calcium or barium. However, it might also be iron, magnesium, cobalt, nickel, manganese, lead, titanium, or the like, or mixtures of two or more of these. Particularly suitable inorganic materials, for use in powdered form, that contain multivalent cations that can be released into the aqueous vehicle, are materials such as barium titanate and other multivalent metal titanates. Other salts, complex salts, and mixtures of salts and oxides, that furnish multivalent cations may also be used, such as, for example, barium metaborate, or a mixture of zinc oxide and barium metaborate.

The invention is also useful in the processing of powdered metals, particularly when subjecting the metal to a passivating procedure.

A composition in accordance with the invention may comprise the aqueous vehicle, the inorganic or metallic powder, and a dispersant prepared in accordance with the present invention. These compositions, in the form of dispersions or slurries, are useful in preparing castings, moldings, films, thrown shapes, free form shapes, coatings, and the like. In many cases it will be desirable to employ a separate binder material in the composition. The binder material may be, for example, another acrylic polymer that is a film-former, preferably one that can be pyrolized without leaving any residuals behind.

The most promising application for the present invention appears to be in the production of cast ceramic articles that can be subjected to a firing, sintering, or fusing operation to form a desired ceramic shape. For this purpose, a formulation or composition according to the invention might contain the neutralized carboxylated acrylic polymer, a ceramic powder, an aqueous vehicle such as demineralized water, and a binder that may be an acrylic copolymer, for example. Both acrylic polymers just mentioned may be water soluble materials. Both polymers should, upon drying, bind the particles together, preferably with sufficient strength so that the green shape thus formed is self-sustaining so that it can be further processed. This green shape may be subjected to pyrolysis to form in the desired shape a ceramic, porcelain, cinder, glaze, or other ultimate product. In particular, the invention should be useful in the preparation of high quality porcelain ware, bone china, ceramic capacitors, ceramic insulators, and ceramic chip carriers, ceramic substrates for thick film printing, and the like.

A particular advantage of the present invention, for the production of high performance ceramics for electronic applications or the like, arises from the fact that the dispersants may be subjected to pyrolysis or firing, and can be burned off to leave essentially no residue of inorganic ions that might act as impurity sites that could impart undesired and uncontrolled changes, from what is desired, in electrical, chemical or physical properties of the final product. Such unwanted sites could possibly serve as sites for chemical attack and premature chemical or mechanical failure of the fired piece.

To attain such high performance, the neutralized acrylic polymer that is used as the dispersant should have a calcium compatability of at least 20 mg and preferably 100 mg of calcium per 1,000 mg of said polymer. These characteristics, coupled with the absence of leaching, result in the production of fired articles that are formed essentially completely from the inorganic powdered material that had been dispersed. Thus, if a dispersion consists, for example, of powdered barium titanate of through 325 mesh size, that is, 44 micrometers in diameter or less, suspended in deionized water with a dispersant that is the salt of tetramethyl ammonium hydroxide with a polyacrylic acid of weight average molecular weight of about 909 atomic mass units, then upon casting, drying and firing, the fired shape will consist essentially of barium titanate with few impurities present, depending upon the purity level of the components of the dispersion, the firing temperature, and the time of exposure to the firing temperature.

Often, it is desirable to include a binder resin in the dispersion to hold the powder in a desired shape after casting, since some of the polymeric dispersants of the invention are not film-formers and are not functional as binders. The use of a wetting agent may also be advantageous, to insure that the powdered material is free from clumps and agglomerates and becomes thoroughly wetted by aqueous vehicle.

A suitable binder may comprise, for example, from 1 percent to about 33 percent, and preferably about 12 percent, by weight of the dispersed powder, of a synthetic resin binder that forms a film upon drying. A suitable binder could be, for example, an acrylic copolymer such as a copolymer of ethyl acrylate, methyl methacrylate and acrylic acid. One advantage of using such an acrylic copolymer is that it can be expected to pyrolize at approximately the same firing temperature as the dispersant.

While the dispersants of the invention have wide applicability, they generally must be designed to have a dispersing activity for the particular powder that is being dispersed, and in addition, must be stable in solution to the presence of those metallic cations that may be released by the powder into the slurry. Custom-designing the neutralized acrylic polymer is something those skilled in the art can readily do when instructed in the present invention. Thus some powdered materials may require a high degree of carboxylation, and only partial neutralization, for good dispersing, for example.

Generally the weight average molecular weight of the neutralized acrylic polymer dispersant, prior to neutralization, should be in the range of from about 500 to about 10,000, and more preferably in the range from about 850 to 1250, and most preferably, from about 850 to about 950.

The invention will now be demonstrated in greater detail by the description of an example. In this example and elsewhere throughout this specification, all parts and percentages are by weight and all temperatures are in degrees Celsius, unless expressly stated to be otherwise.

Example

Formation of a Ferroelectric Tape

A thick paste of barium titanate (Ticon "C" from TAM Pigments, Inc.) was prepared by mixing 103.5 g of barium titanate with 35.5 g demineralized water. The further addition of 1.9 g of a 33% solids solution of polyacrylic acid having $M_w = 909$, neutralized to an extent of about 95% with tetramethyl ammonium hydroxide, made a very fluid dispersion, to which 46.5 g more of barium titanate was added. The neutralized dispersant was characterized, as to its carboxyl groups, as about 1:8:0.2, i.e. 1 esterified carboxyl for about 1.8 neutralized carboxyls for about 0.2 -COOH form carboxyls, in terms of relative proportions.

At this point the concentration of solids in the dispersion was about 80.5% by weight of the dispersion. The dispersion had a Brookfield viscosity of 480 cps, as measured on an RVT viscometer, No. 5 spindle, at 20 rpm and 25°C. Under the same measurement conditions but at a spindle speed of 50 rpm, the measured viscosity was 264 cps.

A higher solids concentration was attained by adding 30 g more of barium titanate and stirring it in gradually, to achieve a solids concentration of 83% by weight of the dispersion. Using the same RVT viscometer and No. 5 spindle at 25°C, this dispersion was found to have a viscosity of 1,360 cps at 20 RPM and 768 cps at 50 RPM. The dispersion containing 80.5% solids was thick but fluid. The dispersion containing 83% solids was a paste.

The 83% solids paste was then further modified. A previously prepared binder mixture was made up from a copolymer of ethyl acrylate/methyl methacrylate/acrylic acid, as a dispersion in water, partially neutralized with ammonium hydroxide. The amount of binder dispersion added was 25 g, consisting of 10 g of the polymer, dry solids basis, and 15 g of water. In addition, 20 g of barium titanate were added. The slurry was mixed to uniformity to produce a stable formulation having a Brookfield viscosity as measured on the RVT viscometer using No. 5 spindle at 25°C of 1,580 cps at 20 RPM and 936 cps at 50 RPM.

The fact that this formulation was stable is quite remarkable considering its very high content of barium titanate solids. Normally, such formulations must be constantly stirred to prevent settling.

A tape was cast from this binder-containing mixture using a 100 mil coating block and air drawing. The tape was hard and brittle and had good adhesion to glass.

A portion of the formulation was not cast but was retained to permit evaluation of its stability. After one week of standing at room temperature, the formulation exhibited slight settling, but reconstituted readily to a homogenous dispersion upon slight stirring.

A barium titanate tape of this kind is useful in the manufacture of capacitors. Thus, the tape would be printed with electrodes of a platinum-silver alloy. The tape would then be cut into pieces of a desired size, and the individual tape pieces would be stacked one on top of the other, in staggered fashion, with each succeeding printed tape piece projecting from the stack, first to the left, and then to the right. The stack would first be compressed under high pressure to consolidate the stock into a single body; the consolidated stack would then be die cut to make green capacitors, about 50 mils thick, 1/4 inch long, and 1/8 inch wide. Conductors would be painted first on one side of the stack then on the other side of the stack, with each painted conductor being in electrical communication with only those printed electrodes on tape pieces projecting from that side of the stack. Thus the painted electrodes on one side of the stack would communicate with half of the printed electrodes and the painted electrodes on the other side of the stack would be in electrical communication with the other half of the printed electrodes. The respective printed electrodes on alternating tape pieces would not be in electrical communication with each other so that the stack would form a capacitor. The stack would then be fired to produce a ceramic capacitor.

## General

One basic principle of the invention is that the quaternary ammonium hydroxide-neutralized carboxylated acrylate backbone can be tailor-made to have a desired dispersing activity for the particular inorganic salt powder or metallic powder that is to be used. The custom-designed acrylate polymer must be stable to the presence of those metallic cations that are released by such a powder into the slurry-solution. Thus, the slurry will exhibit good stability, free from precipitation of a complex of the acrylate polymer with a multivalent cation.

Such custom-designing of the acrylate polymer involves the proper selection of the polymerization process, polymer structure, molecular weight, and nature of the copolymer. Thus a common polymerization process is one in which isopropanol or other organic alcohol may be present during polymerization. While the alcohol is usually removed following polymerization, nevertheless there is some esterification. It is important that there be free carboxyl groups along the backbone, however, if the polymer is to serve its intended purpose. When neutralized or at least partially neutralized with a quaternary organic ammonium hydroxide, the polymer can produce excellent slurry stability and, upon casting, drying, and firing, leaves no residual sites that might, for example, create undesirable electrical properties. Molecular weight is important since good water-solubility is easier to achieve when the molecular weight is relatively low and there is a high proportion of polar entities present. The nature of the neutralized copolymer is also important since the polymer (or copolymer) must remain water-soluble.

Those skilled in the art of producing water treating polymers will recognize that it is possible to adjust the stability of polymer molecules that have an acrylic backbone, are water-soluble, and are of the type with which this invention is concerned, to the presence of multivalent cations by several different means. For example, stability may be affected by adjustment of the molecular weight, by using different carboxylated or other anionogenic monomers such as those that have been treated with sulfonic acid or phosphonated; or polymers that have been modified by making them by copolymerization using hydroxylated monomers such as, for example, hydroxyethyl acrylate or methacrylate, hydroxypropyl acrylate or methacrylate, other hydroxylated or polyhydroxylated monomers such as n-methylol acrylamide and n-(2-hydroxyethyl)-acrylamide, and other water-soluble monomers such as acrylamide, vinyl acetate, vinyl acetate subsequently hydrolyzed to vinyl alcohol equivalent, and the like.

The polymeric dispersants of the invention are tailor made by adjusting a large number of variables. Thus the variables include, for example, the monomers, monomer mixture including proportions if a copolymer is to be used, degree of polymerization (Mw), degree of esterification, degree of neutralization, and neutralizing agent. In selecting a particular dispersant, cost considerations may offset performance considerations. Often the neutralizing agent is relatively expensive, so that a lower degree of neutralization may be selected to keep costs down, despite the fact that a higher degree of neutralization may provide superior performance with a particular ceramic precursor material.

With a polyacrylic acid having a Mw in the 850-950 range, for example, good results can be expected with a barium titanate dispersion when the carboxyl groups of the polyacrylic acid dispersant are in the approximate proportions of 1 part esterified with propanol, 1 part neutralized with tetramethyl ammonium hydroxide, and 1 part remaining in the carboxyl form; superior results, but at greater present cost, are obtained when the approximate proportions are such 1 of 3 available carboxyl groups of the monomer is esterified, and of the remainder, about 95% are neutralized with tetramethyl ammonium hydroxide. Acceptable results are also obtained outside of the preferred Mw range of 800-1250, when for example the Mw is about 2200, about 16% of the original carboxyl groups present are esterified, and about 50% of the remaining carboxyl groups are neutralized.

Put another way, preferably 12% to 80% of the polymeric dispersant comprises -COOH groups; from 10% to 100% of the -COOH groups of the dispersant are neutralized; so that from 1.2% to 80% by weight of the dispersant comprises carboxyl groups that have been neutralized.

The invention is broadly useful in connection with slurries of inorganic materials such as salts, that may be complex, and that contain at least one multivalent cation. Among the salts that may be mentioned are the vanadates, zirconates, silicates, and molybdates. Barium titanate is particularly useful since its properties are useful in electronic and electrical applications. Similarly, calcium titanate and strontium titanate are also useful. These titanates have a perovskite structure. It is expected that the invention would also be useful with titanate salts having an ilmenite structure such as, for example: $FeTiO_3$, $MgTiO_3$, $MnTiO_3$, $CoTiO_3$, and $NiTiO_3$. Similarly, salts having a spinel structure should be useful in compositions involving the practice of the invention, such as, for example: $Mg_2TiO_4$, $Zn_2TiO_4$, and $CoTiO_4$.

The invention should further be useful in compositions having a high pigment content, where the multivalent cation may be, for example, lead, zinc, barium, or titanium. Satin white is another example of such a pigment.

The invention is also useful in the processing of metallic powders including alloy powders, where the powder in suspension in deonized water may nevertheless release multivalent cations into the water. This might occurr, for example, where the water, despite being distilled and deionized, nevertheless contains a small residual amount of an acidic ingredient, which, might be, for example, carbon dioxide from the air.

The invention would also be useful in connection with metallic powders in passivating applications. Zinc and silver powders might be useful in such a situation, where the metallic powder is treated to remove a surface layer of oxygen, for example, and to replace it either with a fresh oxide layer or with an anion of a different nature such as, for example, phosphate.

## CONCLUSION

While the invention has been disclosed in this patent application by reference to the details of preferred embodiments of this invention, it is to be understood that this disclosure is intended in an illustrative rather than in a limiting sense, as it is contemplated with modifications will readily occur to those skilled in the art, within the spirit of the invention and the scope of the appended claims.

## Claims

1. A water-soluble polymer comprising an acrylic backbone and further comprising carboxyl groups disposed at spaced locations along said backbone, for use in dispersing a powder that in an aqueous medium can release multivalent metal ions into the aqueous medium, said polymer being reacted with a water-soluble quaternary ammonium hydroxide that neutralizes at least some of said carboxyl groups, and

**0 260 577**

said neutralized polymer being stable in aqueous solution against precipitation as a metal-polymer complex at a concentration in said medium of multivalent cation released from said powder into said aqueous medium, where the polymer concentration is sufficient to effect dispersion of said powder.

2. The polymer of claim 1 comprising a copolymer of acrylic acid and at least one comonomer selected from the group consisting of alkyl esters of acrylic or methacrylic acid, polyhydroxy or hydroxy alkyl acrylates or methacrylates, 2-acrylamido-2-alkyl-alkane sulfonic acid, acrylamide, methacrylic acid, and mixtures thereof.

3. The polymer of claim 1 wherein said quaternary ammonium hydroxide is a tetra-(lower alkyl) quaternary ammonium hydroxide.

4. The polymer of claim 1 wherein said quaternary ammonium hydroxide is an alkyl aryl quaternary ammonium hydroxide.

5. The polymer of claim 1 wherein said polymer contains at least 12% of -COOH groups, either as such or, if in esterified form, calculated as -COOH, by weight based on the weight of said polymer, prior to reaction with said quaternary ammonium hydroxide.

6. The polymer of claim 1 wherein said polymer contains from 1.2% to 80% by weight of said polymer of neutralized carboxyl groups.

7. The polymer of claim 1 wherein said polymer is present in an aqueous composition in which said polymer is dissolved, and said composition also comprises up to 50% by weight of said polymer of acrylic acid monomer, solids basis.

8. The polymer of claim 1 wherein said polymer, prior to neutralization with said quaternary ammonium hydroxide, has a calcium compatability of at least 20 mg of calcium per 1,000 mg of said polymer.

9. A water soluble polymer selected from the group consisting of homopolymers of acrylic acid and copolymers of acrylic acid with at least one comonomer selected from the group consisting of polyhydroxy and hydroxy alkyl acrylates and methacrylates, 2-acrylamido-2-lower alkyl-lower alkane sulfonic acid, acrylamide, methacrylic acid, and mixtures thereof, said polymer having an acrylic backbone and having carboxyl groups disposed at spaced locations along said backbone, for use in dispersing a powder in an aqueous medium, said powder in said aqueous medium being capable of releasing multivalent metal ions into the aqueous medium, said polymer being reacted with a water-soluble lower alkyl quaternary ammonium hydroxide that neutralizes at least some of said carboxyl groups, and said neutralized polymer being stable in solution against precipitation as a metal-polymer complex at a concentration in said medium of multivalent cation released from said powder of at least 20 mg of said cation for 1,000 mg of neutralized polymer in said medium.

10. The polymer of claim 9 wherein said polymer, prior to neutralization, has a calcium compatability of at least 100 mg of calcium per 1,000 mg of said polymer.

11. The polymer of claim 9 wherein said polymer has a weight average molecular weight in the range from about 500 to about 10,000.

12. The polymer of claim 11 wherein the weight average molecular weight of said polymer is in the range from about 800 to about 1250.

13. The polymer of claim 11 wherein said polymer is a homopolymer of acrylic acid having a weight average molecular weight in the range from about 850 to about 950 and said quaternary ammonium hydroxide is tetramethyl ammonium hydroxide.

14. The polymer of claim 9 for use in dispersing in an aqueous medium a powder that is selected from the group consisting of a multivalent metal powder and a salt of at least one multivalent metal.

15. The polymer of claim 13 for use in dispersing in an aqueous medium a powder selected from the group consisting of a multivalent metal powder and a salt of at least one multivalent metal.

16. An aqueous slurry comprising an aqueous vehicle, and dispersed therein a powder that can release multivalent metal cations into said vehicle, and a water-soluble polymeric dispersant dissolved in said aqueous vehicle and comprising an acrylic backbone having carboxyl groups disposed at spaced locations along said backbone, said polymer being effective to disperse said powder in said aqueous vehicle, said polymer being reacted with a water-soluble quaternary ammonium hydroxide that neutralizes at least some of said carboxyl groups, and said neutralized polymer being stable in solution against precipitation as a metal-polymer complex at the concentration in said vehicle of multivalent cation released from said powder into said vehicle.

17. The slurry of claim 16 that, upon casting, drying, and firing, at a temperature sufficiently high to pyrolize said polymer, is characterized by the essential absence of multivalent cations leached from said powder by said neutralized polymer.

9

18. The slurry of claim 16 wherein said polymer is selected from the group consisting of homopolymers of acrylic acid and copolymers of acrylic acid with at least one comonomer selected from the group consisting of polyhydroxy and hydroxy alkyl acrylates and methacrylates, 2-acrylamido-2-lower alkyl-lower alkane sulfonic acid, acrylamide, methacrylic acid, and mixtures thereof, said polymer having a weight average molecular weight in the range from about 500 to about 10,000.

19. The slurry of claim 18 wherein said polymer is a homopolymer of acrylic acid having a weight average molecular weight in the range from about 850 to 950 and said quaternary ammonium hydroxide is tetramethyl ammonium hydroxide.

20. The slurry of claim 19 wherein said dispersed powder is a titanate of a multivalent metal selected from the group consisting of calcium, strontium, barium, iron, magnesium, manganese, cobalt and nickle.

21. The slurry of claim 19 wherein said dispersed powder is a multivalent metal salt selected from the group of salts consisting of titanates, vanadates, zirconates, silicates, and molybdates.

22. A shaped green body formed from the slurry of claim 16.

23. A shaped green body formed from the slurry of claim 20.

24. A fired shaped body produced by firing the shaped green article of claim 22.

25. A fired shaped body produced by firing the shaped green article of claim 23.

26. The fired article of claim 25 that is characterized by the essential absence of multivalent cations leached from said powder by said neutralized polymer.

European Patent Office

. Application number

EP 87113093.6

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| A | <u>GB - A - 2 168 062</u> (COATEX)<br>* Claims *<br>-- | 1,7,9,<br>16 | C 08 F 20/06<br>C 08 F 220/06<br>C 08 L 33/02 |
| A | <u>US - A - 4 464 524</u> (KARICKHOFF)<br>* Column 6, lines 22-57; claims *<br>-- | 1,7,9,<br>16 | B 01 F 17/52<br>H 01 G 1/01 |
| A | <u>DE - A1 - 2 840 739</u> (ROHM AND HAAS)<br>* Claims *<br>-- | 1,7,9,<br>16 | |
| A | <u>EP - A2 - 0 143 426</u> (E.I. DU PONT)<br>* Page 9, lines 25-30; page 11, line 6 - page 13, line 27; claims *<br>---- | 1,7,9,<br>16,20-<br>26 | |

### TECHNICAL FIELDS SEARCHED (Int. Cl.4)

C 08 F

C 08 L

B 01 F

C 09 D

H 01 G

C 04 B

The present search report has been drawn up for all claims

| Place of search | Date of completion of the search | Examiner |
|---|---|---|
| VIENNA | 05-01-1988 | TENGLER |